Europäisches Patentamt

European Patent Office

Office européen des brevets

(19)

(11) **EP 1 084 417 B1**

(12) **FASCICULE DE BREVET EUROPEEN**

(45) Date de publication et mention
de la délivrance du brevet:
**21.04.2004 Bulletin 2004/17**

(21) Numéro de dépôt: **99923358.8**

(22) Date de dépôt: **04.06.1999**

(51) Int Cl.⁷: $G01R\ 15/20$

(86) Numéro de dépôt international:
**PCT/CH1999/000247**

(87) Numéro de publication internationale:
**WO 1999/064874 (16.12.1999 Gazette 1999/50)**

(54) **CAPTEUR DE COURANT ELECTRIQUE A LARGE BANDE PASSANTE**

ELEKTRISCHER STROMSENSOR MIT HOHER BANDBREITE

ELECTRIC CURRENT SENSOR WITH WIDE PASSBAND

(84) Etats contractants désignés:
**CH DE FR GB LI**

(30) Priorité: **05.06.1998 CH 122598**

(43) Date de publication de la demande:
**21.03.2001 Bulletin 2001/12**

(73) Titulaire: **LIAISONS
ELECTRONIQUES-MECANIQUES LEM S.A.
1228 Plan-les-Ouates (CH)**

(72) Inventeur: **GUDEL, Claude
F-74100 Le Pas de L'Echelle (FR)**

(74) Mandataire: **Reuteler, Raymond Werner et al
WILLIAM BLANC & CIE,
Conseils en Propriété Industrielle SA,
25, Avenue du Pailly
1220 Les Avanchets/Genève (CH)**

(56) Documents cités:
**EP-A- 0 670 502          US-A- 5 493 211**

**Description**

La présente invention concerne un capteur de courant électrique pour la mesure d'un courant passant dans un conducteur primaire, ce capteur comportant un circuit magnétique agencé pour être couplé avec ledit conducteur primaire, un enroulement secondaire couplé avec ce circuit magnétique, une résistance d'amortissement dudit enroulement, un détecteur de champ magnétique disposé dans un entrefer dudit circuit magnétique, un dispositif d'alimentation dudit enroulement secondaire, ce dispositif d'alimentation étant commandé par le détecteur de champ magnétique de manière à fournir, à l'enroulement secondaire, un courant de compensation tendant à compenser le champ magnétique créé dans l'entrefer par le courant primaire, et une résistance de mesure connectée en série avec l'enroulement secondaire, la chute de tension sur cette résistance formant le signal de mesure du capteur.

Dans les capteurs de ce type, la résistance d'amortisssement associée à l'enroulement secondaire influence le résultat de la mesure selon le domaine de fréquence dans lequel se situe le courant à mesurer et ses composantes harmoniques. En effet, dans le domaine des basses fréquences, c'est-à-dire du courant continu jusqu'à une fréquence de transition, le capteur fonctionne en un mode de compensation dans lequel un courant de compensation est injecté dans l'enroulement secondaire de manière à compenser, par le champ magnétique créé par ce courant de compensation, le champ magnétique engendré par le courant primaire dans l'entrefer du circuit magnétique. Le courant passant dans la résistance de mesure présente ainsi une composante due à la présence de la résistance d'amortissement de l'enroulement secondaire, qui s'ajoute au courant de compensation au sens strict, c'est-à-dire à la composante qui, en l'absence de résistance interne de l'enroulement, suffirait à compenser le champ magnétique engendré par le courant primaire.

La mesure présente donc dans le domaine des basses fréquences une erreur positive.

En revanche, dans le domaine des fréquences plus élevées que la fréquence de transition susmentionnée et jusqu'à une fréquence de coupure haute, le capteur travaille en transformateur d'intensité de courant. L'intensité du courant passant dans la résistance de mesure est, dans ce cas, inférieure à la valeur exacte de mesure du courant primaire du fait de la présence de la résistance d'amortissement de l'enroulement secondaire, de sorte que la mesure est affectée d'une erreur négative.

Dans la publication EP-A-0607502, un dispositif de mesure de courant électrique comporte un élément à effet Hall pour détecter un champ magnétique créé par le courant électrique d'un conducteur primaire et un circuit de compensation pour créer un champ magnétique tendant à annuler le champ magnétique créé par le conducteur primaire. L'élément à effet Hall est muni de quatre résistances formant un Pont de Wheatstone permettant le contrôle du courant de compensation et la mesure du courant électrique dans le conducteur primaire.

La présente invention vise notamment à corriger, dans l'un et l'autre des cas susmentionnés, c'est-à-dire dans toute la bande passante du capteur de courant, l'erreur de mesure due à la résistance ohmique de l'enroulement secondaire et à la résistance d'amortissement de cet enroulement.

A cet effet, le capteur selon l'invention est caractérisé en ce qu'il comporte une résistance auxiliaire de même valeur que la résistance d'amortissement de l'enroulement secondaire, connectée au point de connexion commun de l'enroulement secondaire et de la résistance de mesure, et un ensemble amplificateur de différence agencé de façon à mesurer la tension apparaissant aux bornes de l'enroulement secondaire et à appliquer, à ladite résistance auxiliaire, une tension égale et de sens contraire à celle qui apparaît aux bornes de l'enroulement secondaire.

D'autres aspects, buts et avantages de l'invention ressortiront de la description suivante d'un exemple de réalisation illustré dans le dessin annexé, dans lequel:

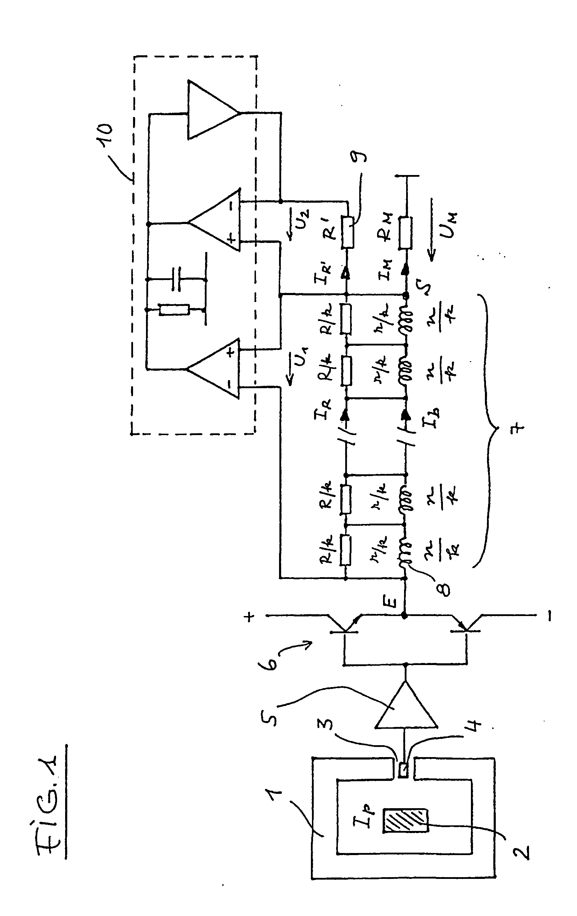

la Fig. 1 est un schéma électrique d'un capteur de courant selon l'invention.

La Fig. 1 montre, schématiquement, un circuit magnétique 1 à l'intérieur duquel passe un conducteur primaire 2, montré en coupe, ce conducteur étant parcouru par un courant primaire à mesurer $I_p$. Le circuit magnétique 1 présente un entrefer 3 dans lequel est disposé un détecteur de champ magnétique, par exemple un élément de Hall 4. Le signal de sortie du détecteur 4 est appliqué à un amplificateur 5 dont la sortie commande un étage de puissance 6. La borne de sortie E de cet étage 6 est reliée à une première borne d'un enroulement secondaire 7 représenté par son circuit équivalent, la seconde borne S de cet enroulement étant connectée à une résistance de mesure $R_M$ reliée à la masse.

L'enroulement secondaire 7 formé par n spires disposées sur le circuit magnétique 1 est représenté par une série de k paquets de spires, tels que 8, comprenant chacun n/k spires de résistance interne r/k et comportant une résistance d'amortissement représentée par une résistance R/k connectée en parallèle à chaque paquet de n/k spires. La résistance d'amortissement de l'ensemble de l'enroulement secondaire est ainsi égale à R.

Le courant de mesure $I_M$ traversant la résistance de mesure $R_M$ et permettant de recueillir, aux bornes de celle-ci, la tension de mesure $U_M$ devrait être, en l'absence des résistances d'amortissement, égale à $I_P/n$.

Du fait de la présence de la résistance d'amortissement R aux bornes de l'enroulement secondaire, le courant passant dans cet enroulement secondaire présente en réalité deux composantes, à savoir le courant de compensation proprement dit $I_b$ et un courant d'amortissement $I_R$. Par conséquent, en l'absence de l'agencement selon l'invention, l'intensité du courant de mesure $I_M$ est

dans le domaine des basses fréquences

$$I_M = I_b + I_R \,,$$

et

dans le domaine des hautes fréquences

$$I_M = I_b - I_R.$$

Selon l'invention, une résistance auxiliaire 9 de valeur R' = R, est connectée à la borne S et un ensemble amplificateur de différence 10 est connecté, selon le schéma de la Fig. 1, par une connection commune de deux entrées positives également à la borne S et, par des entrées correspondantes négatives, respectivement à la seconde borne E de l'enroulement 7 et à la seconde borne de la résistance auxiliaire 9. L'ensemble 10 est agencé de façon à mesurer la tension U, apparaissant aux bornes de l'enroulement secondaire 7 et de façon à créer une tension $U_2$ égale à $U_1$ aux bornes de la résistance 9. Dans ces conditions, un courant $I_{R'}$ = $I_R$ passe dans la résistance 9 et, quelque soit le mode de fonctionnement, $I_M = I_b$. Ainsi, le courant d'amortissement dû à la résistance ohmique de l'enroulement secondaire et à ses résistances d'amortissement n'intervient plus dans la mesure dans toute la bande passante du capteur de courant.

## Revendications

1. Capteur de courant électrique pour la mesure d'un courant passant dans un conducteur primaire (2), ce capteur comportant un circuit magnétique (1) agencé pour être couplé avec ledit conducteur primaire, un enroulement secondaire (7) couplé avec ce circuit magnétique, une résistance d'amortissement dudit enroulement, un détecteur de champ magnétique (4) disposé dans un entrefer (3) dudit circuit magnétique, un dispositif d'alimentation dudit enroulement secondaire, ce dispositif d'alimentation étant commandé par le détecteur de champ magnétique de manière à fournir, à l'enroulement secondaire, un courant de compensation ($I_b$) tendant à compenser le champ magnétique créé dans l'entrefer par le courant primaire, et une résistance de mesure ($R_m$) connectée en série avec l'enroulement secondaire, la chute de tension sur cette résistance formant le signal de mesure du capteur, **caractérisé en ce qu'**il comporte une résistance auxiliaire (9) de même valeur que la résistance ohmique d'amortissement de l'enroulement secondaire, connectée au point de connexion commun de l'enroulement secondaire et de la résistance de mesure, et un ensemble amplificateur de différence (10) agencé de façon à mesurer la tension ($U_1$) apparaissant aux bornes de l'enroulement secondaire et à appliquer, à ladite résistance auxiliaire, une tension ($U_2$) égale et de sens contraire à celle qui apparaît aux bornes (E, S) de l'enroulement secondaire.

## Patentansprüche

1. Stromsensor zur Messung eines durch einen Primärleiter (2) fließenden Stroms, wobei dieser Sensor einen Magnetkreis (1), der angeordnet ist, um mit dem Primärleiter gekoppelt zu werden, eine mit diesem Magnetkreis gekoppelte Sekundärwicklung (7), einen Dämpfungswiderstand dieser Wicklung, einen Magnetfelddetektor (4), der in einem Magnetspalt (3) des Magnetkreises angeordnet ist, eine Stromzufuhrvorrichtung für die Sekundärwicklung, wobei diese Stromzufuhrvorrichtung vom Magnetfelddetektor gesteuert wird, um an die Sekundärwicklung einen Kompensationsstrom ($I_b$) zu liefern, der die Tendenz hat, das im Magnetspalt vom Primärstrom erzeugte Magnetfeld zu kompensieren, und einen Messwiderstand ($R_m$) aufweist, der mit der Sekundärwicklung in Reihe geschaltet ist, wobei der Spannungsabfall in diesem Widerstand das Messsignal des Sensors bildet, **dadurch gekennzeichnet, dass** er einen Hilfswiderstand (9) gleichen Werts wie der Dämpfungswiderstand der Sekundärwicklung, der mit dem der Sekundärwicklung und dem Messwiderstand gemeinsamen Verbindungspunkt verbunden ist, und eine Differenzverstärkungseinheit (10) aufweist, die so gestaltet ist, dass sie die an den Klemmen der Sekundärwicklung auftretende Spannung ($U_1$) misst und an den Hilfswiderstand eine Spannung ($U_2$) anlegt, die gleich der und von umgekehrtem Vorzeichen wie diejenige ist, die an den Klemmen (E, S) der Sekundärwicklung auftritt.

## Claims

1. Electric current sensor for measuring a current flowing through a primary conductor (2), this sensor comprising a magnetic circuit (1) arranged to be coupled with said primary conductor, a secondary winding (7) coupled with this magnetic circuit, a damping resistance of said winding, a magnetic field detector (4) arranged within an air gap (3) of said magnetic circuit, a current supply device for said secondary winding, where this current supply device is controlled by the magnetic field detector so as to feed to the secondary winding a compensating current ($I_b$) which tends to compensate the magnetic field created in the air gap by the primary current, and a measuring resistor ($R_m$) connected in series with the secondary winding where the voltage drop across this resistors forms the measuring signal of the sensor, **characterised in that** it comprises an auxiliary resistor (9) which has the same value of resistance as the ohmic damping resistance of the secondary winding and is connected to the common branch point of the secondary winding and the measuring resistor, and a differential amplifier block (10) arranged so as to measure the voltage ($U_1$) appearing at the terminals of the secondary winding and to apply to said auxiliary resistor a voltage ($U_2$) of the same size but opposite in direction to that appearing at the terminals (E, S) of the secondary winding.

FIG.1

EP 1 084 417 B1